# EUROPÄISCHE PATENTSCHRIFT

(11) **EP 2 668 470 B1**
(45) Veröffentlichungstag und Bekanntmachung des Hinweises auf die Patenterteilung: **13.03.2019**
(21) Anmeldenummer: 12701724.2
(22) Anmeldetag: 23.01.2012
(51) Int. Cl.: G01D 4/00, G01R 22/06, H02J 3/38

(54) **VERFAHREN ZUM EINSPEISEN VON ENERGIE IN EIN ENERGIENETZ**
METHOD FOR SUPPLYING ENERGY TO AN ENERGY NETWORK
PROCÉDÉ POUR INJECTER DE L'ÉNERGIE DANS UN RÉSEAU FOURNISSEUR D'ÉNERGIE

(30) Priorität: 26.01.2011 DE 102011003149
(43) Veröffentlichungstag der Anmeldung: 04.12.2013
(73) Patentinhaber: Robert Bosch GmbH, 70442 Stuttgart (DE)
(72) Erfinder: BRONNER, Wolfgang, 99084 Erfurt (DE); FEUCHTER, Bernhard, 71336 Waiblingen (DE); BRANDSTETTER, Markus, 74343 Sachsenheim (DE); BERLIN, Katja, 68169 Mannheim (DE)
(86) Internationale Anmeldenummer: PCT/EP2012/050959
(87) Internationale Veröffentlichungsnummer: WO 2012/101084

(56) Entgegenhaltungen:
- WO-A1-2009/149731

## Beschreibung

Die Erfindung betrifft ein Verfahren zum Einspeisen von elektrischer Energie in ein Energienetz und eine Anordnung zum Verifizieren von in ein Stromnetz eingespeister elektrischer Energie, insbesondere zur Durchführung des Verfahrens.

### Stand der Technik

Die Einspeisung von Energie in Energienetze wird im allgemeinen entlohnt. Je nach Energiegewinnungsform entstehen dabei unterschiedliche Kosten, die teilweise auch unterschiedlich entlohnt werden. Bekannt ist bspw. die Förderung von erneuerbaren Energien in Deutschland nach dem Erneuerbaren-Energien-Gesetz (EEG). Dieses soll dazu dienen, im Interesse des Klima- und Umweltschutzes eine nachhaltige Entwicklung der Energieversorgung zu ermöglichen, die volkswirtschaftlichen Kosten der Energieversorgung durch die Einbeziehung langfristiger externer Effekte zu verringern, fossile Energieressourcen zu schonen und die Weiterentwicklung von Technologien bspw. zur Erzeugung von Strom aus erneuerbaren Energien zu fördern.

Bei dem hierin genannten Beispiel erhalten nach dem EEG Anlagebetreiber 15 bis 20 Jahre eine festgelegte Vergütung für ihren erzeugten Strom und die Netzbetreiber werden zu dessen vorrangiger Abnahme verpflichtet.
Hierbei ist zu beachten, dass bisherige Einspeisesysteme keinerlei Möglichkeit zur Validierung bereitstellen, ob tatsächlich die eingespeiste und abgerechnete Energiemenge (Strommenge) aus dem Erzeugersystem geliefert wird, für das eine Förderung, wie bspw. in Deutschland nach EEG, geleistet wird.

Als beispielhafter Anwendungsfall sind gemäß EnWG (§ 3 Nr. 7) Betreiber von Elektrizitäts- und Gasverteilernetzen natürliche oder juristische Personen oder rechtlich unselbständige Organisationseinheiten eines Energieversorgungsunternehmens, die die Aufgabe der Verteilung von Elektrizität und Gas wahrnehmen. Außerdem sind diese verantwortlich für den Betrieb, die Wartung sowie erforderlicherweise für den Ausbau des Verteilernetzes in einem bestimmten Gebiet und gegebenenfalls auch für den Ausbau der Verbindungsleitungen zu anderen Netzen.

Weiterhin ist im EnWG (§ 12) geregelt, dass Betreiber von Übertragungsnetzen die Energieübertragung durch das Netz unter Berücksichtigung des Austauschs mit anderen Verbundnetzen zu regeln haben und mit der Bereitstellung und dem Betrieb ihrer Übertragungsnetze im nationalen und internationalen Verbund zu einem sicheren und zuverlässigen Elektrizitätsversorgungssystem in ihrer Regelzone und damit zu einer sicheren Energieversorgung beizutragen haben. Betreiber von Übertragungsnetzen haben dauerhaft die Fähigkeit des Netzes sicherzustellen, die Übertragung von Elektrizität zu befriedigen und insbesondere durch eine entsprechende Übertragungskapazität und Zuverlässigkeit des Netzes zur Versorgungssicherheit beizutragen.

Gemäß § 14 EnWG sind Betreiber von Elektrizitätsverteilernetzen dazu verpflichtet, Maßnahmen des Betreibers von Übertragungsnetzen, in dessen Netz sie unmittelbar oder mittelbar technisch eingebunden sind, nach dessen Vorgaben durch eigene Maßnahmen zu unterstützen, soweit dies erforderlich ist, um Gefährdungen und Störungen in den Übertragungsnetzen zu vermeiden. Bei der Planung des Verteilernetzausbaus haben Betreiber von Elektrizitätsverteilernetzen die Möglichkeit, Energieeffizienz- und Nachfragesteuerungsmaßnahmen von dezentralen Erzeugungsanlagen zu berücksichtigen. In diesem Zusammenhang versteht man unter einem Messstellenbetreiber einen Netzbetreiber oder einen Dritten, der die Aufgaben des Messstellenbetriebs übernimmt. Ein Netznutzer ist eine natürliche oder juristische Person, die Energie in ein Elektrizitäts- oder Gasversorgungsnetz einspeist und/oder daraus bezieht.

Es scheint erforderlich, den gemäß EnWG verpflichteten Betreibern von Energienetzen eine Möglichkeit zu geben, zu überprüfen, ob die eingespeiste und abgerechnete Energiemenge tatsächlich aus dem dafür vorgesehenen Erzeugersystem, das gefördert werden soll, geliefert wird. Dies wird nachfolgend als Validierung bzw. Verifizierung der Einspeisung bezeichnet.

Darüber hinaus kann bei dem Nachweis und der Kommunikation der aktuell erzeugten Energiemenge mit dem Erzeugertyp auch bspw. ein anderer Erzeugungsmix ermittelt werden, der je nach Anteil an regenerativen Energien es erlaubt, eine andere CO₂-Belastung für die abnehmende Industrie auszuweisen und damit Kosten für CO₂-Zertifikate zu ent- oder belasten.

Aus der WO 2009/149731 A1 ist ein System zur manipulationsgeschützten Erfassung einer Stromeinspeisemenge bekannt.

### Offenbarung der Erfindung

Vor diesem Hintergrund werden ein Verfahren nach Anspruch 1 und eine Anordnung mit den Merkmalen des Anspruchs 6 vorgestellt. Ausgestaltungen ergeben sich aus den abhängigen Ansprüchen und der Beschreibung.

Das hierin vorgestellte Verfahren ist in der Lage, unterschiedliche Arten von Missbrauch bei der Einspeisung zur Abrechnung über den Einspeisezähler zu detektieren. Dies umfasst sowohl die wechselspannungsseitige Fehleinspeisung an dem Abrechnungsträger als auch eine gleichstrombasierende Zusatz- oder Ersatzeinspeisung an einem vorgeschalteten Wechselrichter.

Die Erfindung ermöglicht eine Validierung der Einspeisemengen sowohl mit als auch ohne Kommunikationsschnittstellen über "smart meter" (elektronische Zähler mit Kommunikationseinrichtung). Sie kann somit sowohl bei dem klassischen papiergestützten Abrechnungsweg als auch bei der papierlosen Abrechnung im Rahmen der Kommunikationslösungen im "smart grid" (intelligentes Stromnetz, intelligentes Gasnetz, intelligentes Wärmenetz) als Bestandteil des Internets der Energie eingesetzt werden.

### (Fortsetzung ursprüngliche Beschreibungsseiten 4 bis 10)

Das vorgestellte Verfahren unterstützt dabei jede regulative oder normierende Vorschrift zur Validierung der zählergestützten Ersatzmessung. Gleichzeitig kann das Verfahren selbst die Basis zu einem Regulierungs- oder Normierungsvorhaben bilden.

Durch die in Ausgestaltung vorgesehene Datenverschlüsselung, insbesondere gemäß den Bestimmungen zur Fernzählerauslesung, werden Dateninhalte dem allgemeinen Zugriff entzogen und zudem die Manipulation des Systems wirtschaftlich unattraktiv gemacht. Das beschriebene Verfahren funktioniert unabhängig davon, ob die erzeugte Nutzenergie in einen Selbstverbraucherbetrieb oder in das öffentliche Stromnetz eingespeist wird. Es ist sowohl eine aktiv abschaltende als auch eine rein berichtende Funktion umfasst.

Als Sonderfunktionen sind zudem über die vorgestellte kommunikative Integration auch weitere Management-Datendienste bzgl. des Energie erzeugenden Systems realisierbar.

Zu beachten ist, dass nicht die Einrichtung eines spezifischen proprietären Verifikationsprotokolls zur Kommunikation verlangt wird. Es wird vielmehr die Methodik der Verifikation beschrieben. So können zum Transport der Daten bspw. auch die bekannte Sub-metering M-Bus-Schnittstelle bis hin zu Zigbee-Funktransport oder auch einem Service-Protokoll über IP mit Powerline-Protokoll eingesetzt werden.

Weiterhin bieten das vorgestellte Verfahren und die beschriebene Anordnung die Option, in der direkten elektronischen online-Integration durchgängig ökologisch erzeugte Energie von der Quelle bis zum Energieverbrauch oder zur Einspeisung als solchen zu identifizieren und zu unterscheiden. Es erfolgt somit eine Verifizierung der eingespeisten Energie und optional eine Kennzeichnung der Energieart.

Die Einspeisung ist dabei nicht auf die Einspeisung in das "klassische" öffentliche Stromnetz beschränkt. Weitere Anwendungen finden sich bei sogenannten Micro-Grids in Emerging Markets. Vernetzung kann auch bedeuten, dass ein Verbraucher und/oder Erzeuger direkt ein Kabel zu einem weiteren Verbraucher und/oder Erzeuger legt, ohne auf die vorhandene Netzinfrastruktur zurückzugreifen.

Die beschriebenen Energieflüsse sind nicht auf die reine Erzeugung beschränkt, sondern umfassen jegliche Energieflussart, auch die Speicherung, wie bspw. der Energiefluss in einen Speicher, der auch mobil in einem Kraftfahrzeug vorgesehen sein kann.
Weitere Vorteile und Ausgestaltungen der Erfindung ergeben sich aus der Beschreibung und den beiliegenden Zeichnungen.
Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Kurze Beschreibung der Zeichnungen
Figur 1 zeigt eine Ausführung eines Energieeinspeisesystems.
Figur 2 zeigt eine Ausführung der Anordnung zum Verifizieren mit einem Energieeinspeisesystem nach Figur 1.
Figur 3 zeigt eine weitere Ausführung der Anordnung zum Verifizieren.
Figur 4 zeigt eine beispielhafte erfindungsgemäße Implementierung einer Ausführung der Anordnung zum Verifizieren in einem Photovoltaik-Wechselrichter.

### Ausführungsformen der Erfindung

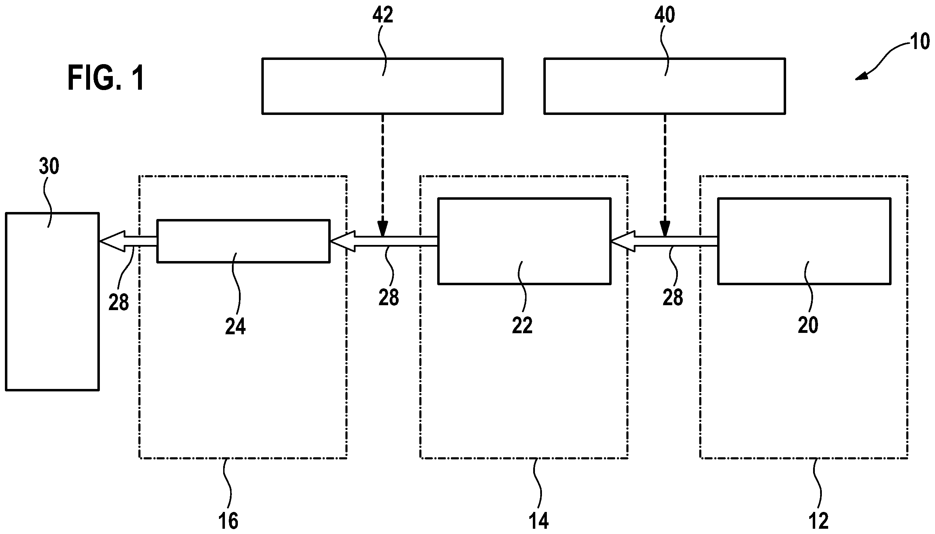

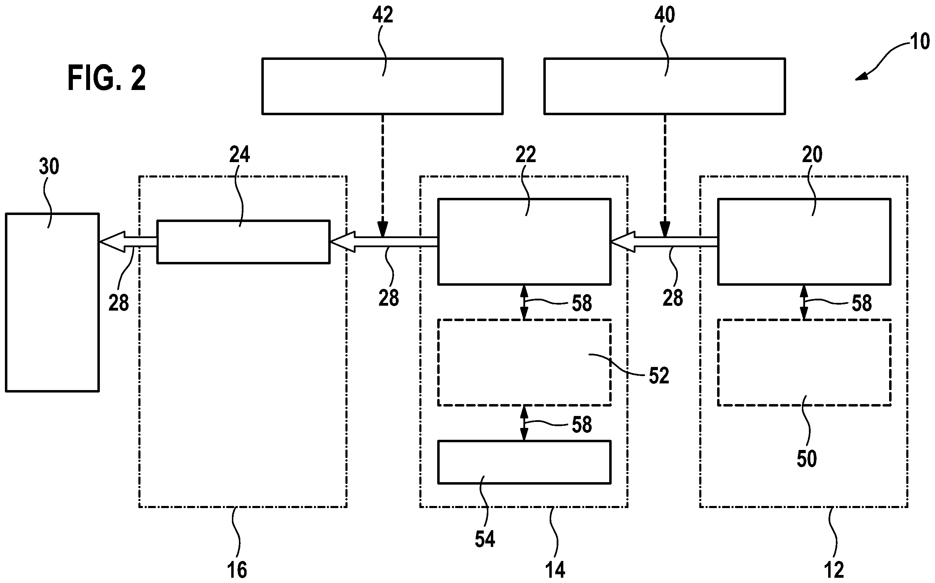

Die in den Figuren 1 und 2 gezeigten Vorrichtungen dienen der Erläuterung der Erfindung und fallen nicht unter den in den unabhängigen Ansprüchen definierten Gegenstand der Erfindung. Die Erfindung wird nachfolgend unter Bezugnahme auf die Zeichnungen ausführlich beschrieben.

In Figur 1 ist einer schematischen Darstellung eine Ausführung eines Energieeinspeisesystems, das insgesamt mit der Bezugsziffer 10 bezeichnet ist, dargestellt. Dieses System 10 umfasst einen Erzeuger 12, einen Wandler 14 und einen Einspeisezähler 16. In dem Erzeuger 12 ist ein Zähler 20 mit Anzeige vorgesehen. Ebenso umfasst der Wandler 14 einen Zähler 22 mit Anzeige. In dem Einspeisezähler 16 ist ein geeichter Zähler 24 vorgesehen. Pfeile 28 verdeutlichen die Flussrichtung elektrischer Leistung hin zu einem Netzanschluss 30, der ein- oder drei-phasig ausgebildet sein kann.

Figur 1 zeigt somit die Ausgangssituation des Energieeinspeisesystems 10 mit folgenden Systemkomponenten: Netzanschluss 30 in das Energienetz- oder das Eigenverbrauchssystem, geeichter Einspeisezähler 16, dessen Zählung zur Abrechnung dient, und eigentlicher Erzeuger 12, der bspw. Solarmodule, Brennstoffzellen, Generator usw. umfasst, mit dem optionalen Zähler 20 mit Anzeige. Weiterhin ist, wenn aus der erzeugten Energie erst noch eine einspeisefähige Energieform generiert werden muss, der Wandler 14 mit dem optionalen Zähler 22 mit Anzeige vorgesehen. Um die eingespeiste Energiemenge über den Einspeisezähler 16 zu verifizieren, werden zunächst mögliche Manipulationen bzw. Missbräuche untersucht.

Ein Block 40 verdeutlicht einen Missbrauch, bei dem Energie in den Fluss zwischen dem Erzeuger 12 und dem Wandler 14 eingespeist wird. Ein weiterer Block 42 zeigt einen Missbrauch, bei dem Energie zwischen dem Wandler 14 und dem Einspeisezähler 16 eingespeist wird. Dies führt dazu, dass die im Einspeisezähler 16 erfasst Energie nicht derjenigen entspricht, die mit dem Erzeuger 12 generiert wird.

In Figur 2 ist eine mögliche Anordnung zum Verifizieren in Zusammenhang mit einem Energieeinspeisesystem 10 nach Figur 1 dargestellt. Die Anordnung umfasst bei dieser Ausführung in dem Erzeuger 12 ein erstes Kommunikations- und Verifikationsprotokollmodul 50. Im Wandler 14 ist ein zweites Kommunikations- und Verifikationsprotokollmodul 52 und ein Validierungsmodul 54 vorgesehen. Pfeile 58 zeigen die Flussrichtung von Daten- und Steuersignalen.

Bei der in Figur 2 dargestellte Ausführung wird zunächst keinerlei elektronische Kommunikation zwischen den Komponenten des Energieeinspeisesystems 10, nämlich dem Erzeuger 12, dem Wandler 14, dem Einspeisezähler 16 und dem Netzanschluss 30, vorausgesetzt. Der normale Ablauf der Abrechnungsvergütung bei vorgenommener Einspeisung ist dabei bisher entweder die Ablesung des Zählerstands auf dem geeichten Zähler 24 des Messstellenbetreibers oder dessen elektronischer Weiterleitung über diesen Zähler 24. Damit ist aber die Richtigkeit dieser Einspeisung nicht validiert.

Dies wird nun dadurch sichergestellt, dass in dem Wandler 14, wenn ein solcher benötigt wird, und/oder im Erzeuger 12 jeweils ein Kommunikations- und Verifikationsprotokollmodul 50, 52 bereitgestellt ist, das die transportierte Energiemenge ebenfalls zähltechnisch erfasst bzw. misst und damit der Ausschluss einer zusätzlichen Energiemenge über Block 40 und Block 42 sichergestellt wird. Wird direkt Energie vom Erzeuger 12 in den Einspeisezähler 16 eingespeist, entfällt die Möglichkeit gemäß Block 40.

In einer Ausführung des beschriebenen Verfahrens wird dabei der Messwert verschlüsselt kryptisch dargestellt, so dass eine schriftliche Weiterleitung als zusätzlicher Ablesewert durch den Selbstableser ermöglicht wird und dem Validierungsgedanken als auch dem Datenschutz Rechnung getragen wird. Die jeweiligen regulativen und normativen Bedingungen legen entsprechend die Eingreifschwellen und Eingreifmöglichkeiten fest. Je nach regulativem Rahmen kann vorgesehen sein, auch geeichte Zählmodule in dem Wandler 14 oder Erzeuger 12 zu verbauen. Für den Fall, dass der Wandler 14 in der Strecke zwischen dem Erzeuger 12 und dem Einspeisezähler 16 notwendig ist, bestehen prinzipiell zwei Möglichkeiten, die Strecke zwischen dem Erzeuger 12 und dem Wandler 14 zu validieren.

Die erste Möglichkeit sieht das gleiche Vorgehen, wie dies zuvor beschrieben ist, unter Verwendung des funktional gleichen ersten Kommunikations- und Verifikationsprotokollmoduls 50 vor. Es ist dann ein weiterer kryptischer Wert abzulesen oder zu übermitteln. Für die zweite Möglichkeit ist das Validierungsmodul 54 im Wandler 14 vorgesehen, das typische Abweichungen erfasst, die durch den Anschluss einer zweiten Fehleinspeisequelle entstehen, oder das auf ein geändertes Kennlinienverhalten in der Erzeugung reagiert und dieses protokolliert. Diese Abweichungen können ebenfalls in den verschlüsselten Ablesewert hinterlegt werden. Die Auswertung dieser Informationen unterliegt den in den jeweiligen Ländern vorgegebenen regulativen Einspeisegesetzgebungen. Die Annahme, dass keinerlei elektronische Kommunikation zwischen den Komponenten vorliegt schließt jedoch nicht aus, dass das erste Kommunikations- und Verifikationsprotokollmoduls 50, das zweite Kommunikations- und Verifikationsprotokollmoduls 52 und das Validierungsmodul 54 selbst über Kommunikationsmöglichkeiten verfügen, die dem Anwender ein Auslesen an anderen Orten als dem Montageort ermöglichen.

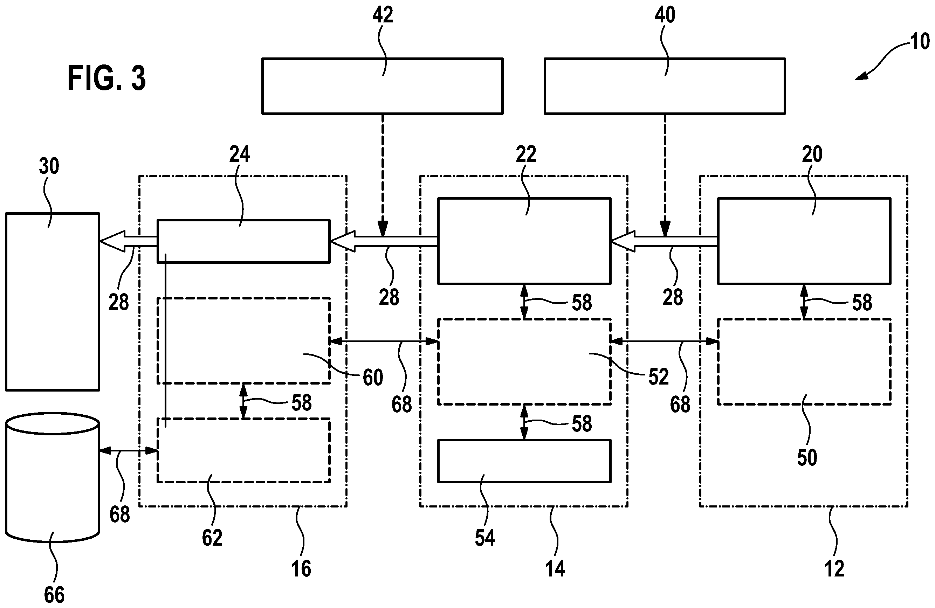

In Figur 3 ist eine weitere Ausführung zur Verifikation einer Einspeisung in Verbindung mit dem Energieeinspeisesystem 10 aus Figur 1 dargestellt. Die in Figur 3 dargestellte Anordnung basiert auf der in Figur 2 dargestellten Anordnung ergänzt um ein drittes Kommunikations- und Verifikationsprotokollmoduls 60 und eine Kommunikationseinrichtung 62 des Messstellenbetreibers in dem Einspeisezähler 16, der in diesem Fall als sogenanntes smart meter ausgebildet ist. Weiterhin sind ein Datenzentrum 66 für die Abrechnung und weitere Pfeile 68 zur Verdeutlichung der Flussrichtung von Daten- und Steuersignalen wiedergegeben.

Figur 3 verdeutlicht eine umfassende automatisierte Form des vorgestellten Verfahrens, die auf der Durchgängigkeit der ITK (Informations- und Telekommunikationstechnologie) basiert, wie sie zukünftig in einem intelligenten Energieversorgungsnetz bzw. "smart grid" oder Internet der Energie möglich sein wird. Durch die Online-Kommunikationsmöglichkeit besteht in der gleichen Form auch die verifizierte Kommunikation des aktuell vorliegenden Energiemixes und damit der CO₂-Belastung von verbrauchter Energie im Wirtschaftsraum.

Es wird somit eine Methodik zur Versorgungssicherheit in einem dezentralen Energienetzwerk zur Verfügung gestellt. Durch die Kommunikationsmöglichkeiten, die Funk, Powerline oder andere Datenkanäle bieten, werden nun die Funktionsmodule miteinander vernetzt. So kann das zweite Kommunikations- und Verifikationsprotokollmodul 52 in dem Wandler 14 nun direkt seine kryptographierten Daten über die Kommunikationseinrichtung 62 des Messstellenbetreibers übermitteln. Diese befindet sich dann typischerweise in dem als smart meter ausgebildeten Einspeisezähler 16 und bedürfen lediglich der Ankopplung an das Validierungssystem mittels einer Übersetzungseinheit, in diesem Fall dem dritten Kommunikations- und Verifikationsprotokollmodul 60 in dem Einspeisezähler 16.

Alternative Kommunikationswege zu dem Datenzentrum 66 des Messstellenbetreibers, Versorgers oder Abrechners können genauso bedient werden, wie es beispielsweise die IEC smart grid Standardisierung festlegen kann, um Zeitsynchronität und Signierung der Daten sicherzustellen. Die Anwendungsszenarien sind des weiteren identisch mit den in Zusammenhang mit Figur 2 beschriebenen Szenarien, lediglich eine online-Fähigkeit liegt nunmehr vor. Fehler und Abweichungen können direkt angezeigt und gehandhabt werden, bspw. kann ggf. zunächst der Anwender, bevor eine Information an den Versorger erfolgt, auf eine vorzunehmende oder bereits vorgenommene Korrektur hingewiesen werden. Ergänzend ist festzuhalten, dass die Kommunikation eines Erzeugers nicht zwingend über den Wandler 14 erfolgen muss. Zusätzlich soll bemerkt werden, dass bei anderen Beispielen die Teilnehmer in dem hier beschriebenen Verifikationsmechanismus als Erzeuger auftreten können, wie auch Batterien oder Speicher, die über elektronische Zähler zur Speicherung und Abgabe verfügen.

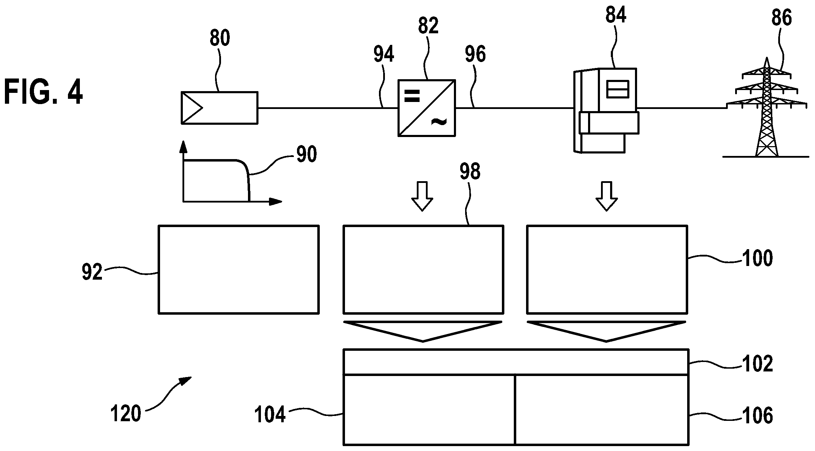

In Figur 4 ist eine beispielhafte Implementierung der erfindungsgemäßen Anordnung 120 zum Verifizieren in einem Photovoltaik-Wechselrichter wiedergegeben. Die Darstellung zeigt einen Solargenerator 80, einen Wechselrichter 82 mit einem DC-Eingang 94 und einem AC-Ausgang 96, einen Einspeisezähler bzw. Einspeisestromzähler 84 und ein Energienetz 86, in diesem Fall ein Stromnetz.
Der Solargenerator 80 ist durch eine Strom-Spannungs-Kennlinie (I-U-Kennlinie) 90 charakterisiert. Es erfolgt, wie mit Block 92 verdeutlicht ist, eine Prüfung der Kennlinie 90 an dem DC-Eingang 94 des Wechselrichters 82, um zu verifizieren, dass tatsächlich ein Solargenerator angeschlossen ist.
Weiterhin ist im Wechselrichter 82 eine neue Funktion (Block 98) vorgesehen. Diese umfasst eine kryptische Anzeige eines verschlüsselten Werts A der am AC-Ausgang 96 des Wechselrichters 82 eingespeisten Leistung. Ebenso ist am Einspeisezähler 84 eine neue Funktion (Block 100) bereitgestellt. Diese ermittelt einen Wert B des Einspeisezählers 84. Dieser Wert B wird bei einer EEG-Abrechnungsstelle 102 eingereicht. In dieser Abrechnungsstelle 102 wird der kryptische Wert A entschlüsselt (Block 104). Der entschlüsselte Wert A wird zur Verifizierung mit dem Wert B (Block 106) verglichen.
Figur 4 veranschaulicht somit ein mögliches Umsetzungsbeispiel des beschriebenen Verfahrens bei der Implementierung im Photovoltaik-Wechselrichter. Dabei werden die gelieferten verschlüsselten Daten des Wechselrichters 82 mit dem Ablesewert des Einspeisezählers 84 in der Abrechnungsstelle 102 abgeglichen und mögliche Fehleinspeisewege identifiziert. Zuvor wird bereits die Kennlinie 90 bzw. die DC-Generatorkennlinie geprüft um sicherzustellen, dass es sich bei dem eingespeisten Strom tatsächlich um Solarstrom gemäß beispielhaft EEG handelt.

Es bleibt festzuhalten, dass bei der Normierung und Standardisierung Methoden zur Vermeidung von Missbrauch der Energieeinspeisung gesucht werden. Mit einer umfassenden Lösung, wie diese hierin beschrieben ist, kann die Diskussion auf eine gemeinsame Plattform zurückgeführt werden. Insbesondere kann das Verfahren bei dezentralen Energieerzeugeranlagen eingesetzt werden, die bisher nicht der Netzkontrolle unterliegen.

## Patentansprüche

1. Verfahren zum Einspeisen von elektrischer Energie in ein Stromnetz, bei dem eine Verifizierung der eingespeisten elektrischen Energie vorgenommen wird, wobei ein an einem Einspeisezähler (16, 84) ermittelter erster Wert mit mindestens einem zweiten Wert, der nach der Erzeugung und vor dem Einspeisen gemessen wird, verglichen wird,
**dadurch gekennzeichnet, dass**
eine Strom-Spannungs-Kennlinie (90) der erzeugten elektrischen Energie an einem DC-Eingang (94) eines Wechselrichters (82) untersucht wird.

2. Verfahren nach Anspruch 1, bei dem der mindestens eine zweite gemessene Wert verschlüsselt und vor dem Vergleich entschlüsselt wird.

3. Verfahren nach Anspruch 1 oder 2, bei dem einer von dem mindestens einen zweiten Wert in einem Erzeuger (12) mittels eines ersten Kommunikations- und Verifikationsprotokollmoduls (50) gemessen wird.

4. Verfahren nach einem der Ansprüche 1 bis 3, bei dem eine von dem mindestens einen zweiten Wert in einem Wandler, (14, 82) mittels eines zweiten Kommunikations- und Verifikationsprotokollmoduls (52) gemessen wird.

5. Verfahren nach einem der Ansprüche 1 bis 4, bei dem durch missbräuchliche Einspeisung erfolgte Abweichungen erfasst werden.

6. Anordnung zum Verifizieren von in ein Stromnetz eingespeister elektrischer Energie, insbesondere zur Durchführung eines Verfahrens nach einem der Ansprüche 1 bis 5, mit mindestens einem Kommunikations- und Verifikationsprotokollmodul (50, 52, 60) zum Messen erzeugter Energie, wodurch mindestens ein zweiter Wert ermittelt wird, der mit einem ersten Wert, der bei einem Einspeisezähler (16, 84) ermittelt wird, zu vergleichen ist,
**dadurch gekennzeichnet, dass** ein Validierungsmodul (54) vorgesehen ist, um eine Strom-Spannungs-Kennlinie (90) der erzeugten elektrischen Energie an einem DC-Eingang (94) eines Wechselrichters (82) zu untersuchen.

7. Anordnung nach Anspruch 5 oder 6, bei dem ein Datenzentrum (66) zur Abrechnung vorgesehen ist.

## Claims

1. Method for feeding electrical energy into a power supply system, in which the electrical energy fed in is verified, wherein a first value identified at an infeed meter (16, 84) is compared with at least one second value, which is measured after the generation and before the infeed,
**characterized in that**
a current/voltage characteristic curve (90) of the generated electrical energy at a DC input (94) of an inverter (82) is determined.

2. Method according to Claim 1, in which the at least one second measured value is encrypted and, before the comparison, is decrypted.

3. Method according to Claim 1 or 2, in which one of the at least one second value is measured in a generator (12) by means of a first communication and verification protocol module (50).

4. Method according to one of Claims 1 to 3, in which one of the at least one second value is measured in a converter (14, 82) by means of a second communication and verification protocol module (52).

5. Method according to one of Claims 1 to 4, in which deviations caused by incorrect infeed are detected.

6. Arrangement for verifying electrical energy fed into a power supply system, in particular for carrying out a method according to one of Claims 1 to 5, having at least one communication and verification protocol module (50, 52, 60) for measuring generated energy, as a result of which at least one second value is identified, which is to be compared with a first value, which is identified in an infeed meter (16, 84),
**characterized in that** a validation module (54) is provided in order to determine a current/voltage characteristic curve (90) of the generated electrical energy at a DC input (94) of an inverter (82).

7. Arrangement according to Claim 5 or 6, in which a data centre (66) is provided for billing.

## Revendications

1. Procédé d'injection d'énergie électrique dans un réseau électrique, selon lequel une vérification de l'énergie électrique injectée est effectuée, une première valeur déterminée au niveau d'un compteur d'injection (16, 84) étant comparée à au moins une deuxième valeur qui est mesurée après la génération et avant l'injection,
**caractérisé en ce que**
une courbe caractéristique courant-tension (90) de l'énergie électrique générée est examinée au niveau d'une entrée CC (94) d'un onduleur (82).

2. Procédé selon la revendication 1, selon lequel au moins une deuxième valeur mesurée est chiffrée et déchiffrée avant la comparaison.

3. Procédé selon la revendication 1 ou 2, selon lequel une parmi l'au moins une deuxième valeur est mesurée dans un générateur (12) au moyen d'un premier module de protocole de communication et de vérification (50) .

4. Procédé selon l'une des revendications 1 à 3, selon lequel une parmi l'au moins une deuxième valeur est mesurée dans un convertisseur (14, 82) au moyen d'un deuxième module de protocole de communication et de vérification (52).

5. Procédé selon l'une des revendications 1 à 4, selon lequel les écarts résultant d'une injection abusive sont détectés.

6. Arrangement destiné à vérifier de l'énergie électrique injectée dans un réseau électrique, notamment destiné à mettre en oeuvre un procédé selon l'une des revendications 1 à 5, comprenant au moins un module de protocole de communication et de vérification (50, 52, 60) servant à mesurer l'énergie générée, par lequel au moins une deuxième valeur est déterminée, laquelle est à comparer à une première valeur qui est déterminée au niveau d'un compteur d'injection (16, 84),
**caractérisé en ce qu'**il existe un module de validation (54) en vue d'examiner une courbe caractéristique courant-tension (90) de l'énergie électrique générée au niveau d'une entrée CC (94) d'un onduleur (82).

7. Arrangement selon la revendication 5 ou 6, avec lequel un centre de données (66) est prévu pour la facturation.
